Europäisches Patentamt

European Patent Office

Office européen des brevets

(11) Publication number: **0 415 412 A2**

# EUROPEAN PATENT APPLICATION

(21) Application number: **90116659.5**

(51) Int. Cl.5: **G03F 7/16, G03F 7/38**

(22) Date of filing: **30.08.90**

(30) Priority: **30.08.89 JP 221686/89**

(43) Date of publication of application:
**06.03.91 Bulletin 91/10**

(84) Designated Contracting States:
**DE FR GB**

(71) Applicant: **KABUSHIKI KAISHA TOSHIBA**
**72, Horikawa-Cho Saiwai-ku**
**Kawasaki-shi Kanagawa-ken(JP)**

(72) Inventor: **Urayama, Kazuhiko**
**2-14-10, Shinkoyasu, Kanagawa-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Resist pattern fabrication method.

(57) Disclosed is a resist pattern fabrication method for forming the resist pattern (20) on a substrate (10) comprises a coating stage for forming a resist film (20) by coating a resist produced by mixing a number of polymer material on the substrate (10), a first heating stage for heating the resist film (20) after installing the substrate in $N_2$ gas or air atomosphere, an exposing stage for exposing the resist film (20), a second heating stage for heating the resist film (20) after instaling the substrate in $N_2$ gas, inert gas, or dry air and finally a development stage for development of the resist film (20). By using the method, an approximately 0.05 improvement of the resolution of the resist pattern (20) is obtained.

# FIG.1A

**EXPOSURE LIGHT**

**MASK PATTERN**
**LENGTH L**

**MASK**
**PATTERN 5**
40

20

**RESIST**
**PATTERN**

10

**RESIST PATTERN**
**LENGTH L1**

# RESIST PATTERN FABRICATION METHOD

## BACKGROUND OF INVENTION

### Field of the Invention

This invention relates to a method for fabricating a resist pattern on a substrate, more particularly to a resist pattern fabrication method having higher resolution.

### Description of the Priort

In general, a lithography method is used for forming a circuit patterns including such as memory elements, gates, and wires. The photolithography method is mainly used particularly in a manufacture of LSI (Large Scale Integrated circuit).

The resist pattern fabrication method will now be described below.

First, a photoresist material as a photosensitive polymer material is coated equally on the substrate with a rotary applicator or spinner for forming a resist film.

Next, the resist film is heated in the atmosphere at a required temperature for a predetermined time, then exposed through a mask pattern and developed. This completes the forming stage of the resist pattern.

The resist pattern is exposed with an optical system which can image an object by a monochromatic light as the exposing light. In this case, a standing wave is yielded in the resist film. Accordingly, the mask pattern can not be transferred exactly on the resist pattern formed in the resist film (resolution drop).

Moreover, there is a problem that change in size of the resist pattern are caused by a little variations in thickness of the resist pattern.

When the resolution of the resist pattern becomes lower and the change of the shape and the size of the resist pattern is produced, a stage for fabricating a circuit pattern and others as later stages can not be performed exactly. For this reason as mentioned above, the productivity of the semiconductor devices is decreased and the producting cost of them is increased.

Previously, the photoresist film is heated in order to achieve the improvement of the resolution of the resist pattern and increase the sensitivity of the exposure in the atomosphere after the exposure stage (The heating stage).

In this case, the improvement of the resolution of the resist pattern and the decreasing the exposure time can be achieved by the heating stages as descrived above. But it is not adequately satisfied.

When a high density and high integrated circuit pattern is required, the fabrication method as described above can not fabricated. Namely, the resolution of the resist pattern obtained by the conventional resist pattern method has a limitation.

As described above, there are particular problems associated with the use of these steps.

## SUMMARY OF THE INVENTION

An object of the invention is to provide a resist pattern fabrication method for forming a high integrated and a high concentrated resist pattern having a high resolution and exactly transferred shape and size.

According to one aspect of the invention, the resist pattern fabrication method comprises a coating stage for forming a resist film by coating a resist on a substrate, a first heating stage for heating the resist film after installing the substrate in a first gas atomosphere, a exposing stage for exposing the resist film, a second heating stage for heating the resist film after installing the substrate in a second gas atomosphere, and a development stage for development of the resist film.

In the first heating stage of this invention, the resist film is heated in the first gas such as inert gas, for example Nitrogen gas ($N_2$ gas) or air. Thereby, the surface of the resist film is not deteriorated in quality by oxidation and bonded closely to the substrate. This resist film is most suitable for the exposing stage.

In the second heating stage, the resist film is heated in the second gas such as inert gas, for example the nitrogen gas ($N_2$ gas) or dry air. Thereby, the unexposed area in the resist film is bonded more strongly to the substrate by oxidation and bonded closely to the substrate.

While, in the exposed area on the resist film, heat diffusion etc. are caused to bond between the exposed area and the substrate by the heating of the second heating stage.

Accordingly, the resist pattern having the high resolution and the exactly fabricated shapes can be obtained by the method according to the invention.

The resist pattern fabrication method is particularly useful in the fabrication of the high integrated semiconductor device.

In addition, the productivity of the semiconductor devices can be increased and the producting costs of them can be decreased.

These and other objects, features and advantages of the present invention will be more apparent from the following description of a preferred embodiment, taken in conjunction with the accompanying drawing.

## BRIEF DESCRIPTON OF DRAWINGS

Fig. 1A is a sectional view of the resist pattern formed by the resist pattern fabrication method of the invention.

Fig. 1B is a sectional view of the resist pattern formed by the conventional resist pattern fabrication method.

Fig. 2 shows a relation between a length of a mask pattern formed by the resist pattern fabrication method of this invention and a length of a resist pattern formed by the conventional resist pattern fabrication method.

## DETAILED DESCRIPTION OF ENBODIMENTS

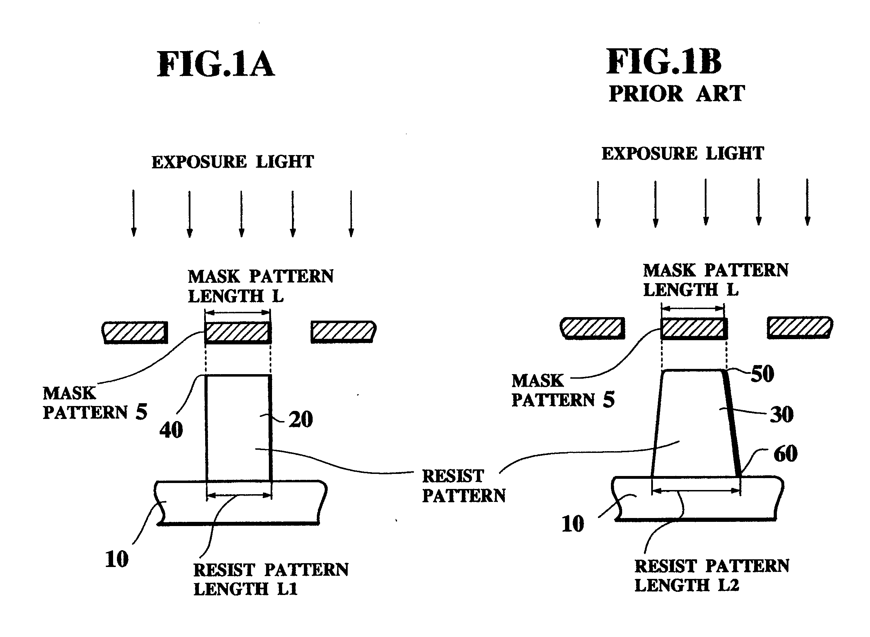

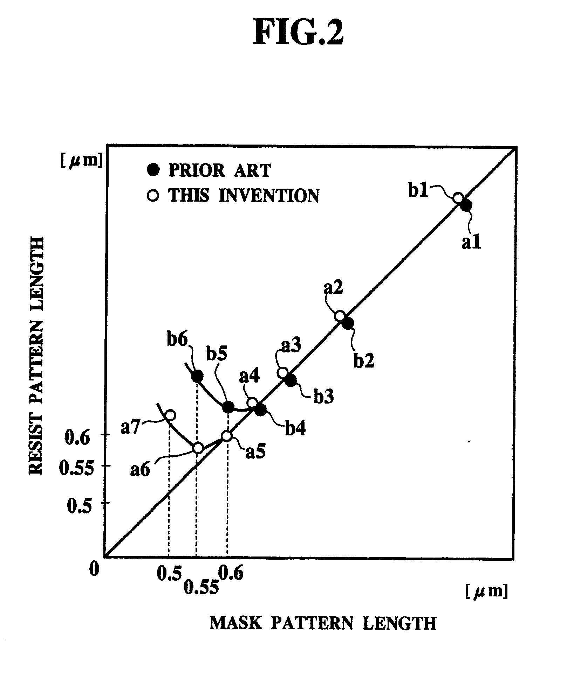

An embodiment of a resist pattern fabrication method according to the invention will now be described with reference to Figs. 1A, 1B, and 2.

In the embodiment, PFR7750 resist manufactured by Nihhon-Gousei Gomu Kabushiki Kaisya (Japan synthesis rubber corporation) was used for forming a resist pattern.

First, a photoresist film was formed by coating the PFR7750 resist on a semiconductor substrate or substrate 10 with a spinner (not shown), (The coating stage).

The final thickness of the photoresist film was controlled to be approximately 1.26 $\mu$m by spin speed of the spinner before an exposure stage.

The rotation speed of the spinner and the coating time for the photoresist film as the condition of the coating stage were at approximately 3000 to 6000 revolutions per minute (r.p.m.) and for 60 minutes, respectively.

These conditions for the coating should be changed depending on the type of photoresist or thickness of it.

Next, the substrate 10 was installed in an inert gas, for example Nitrogen gas ($N_2$ gas). In the stage, a closed-type heating-plate was used for heating the substrate 10.

The substrate 10 was heated for approximately two (2) minutes at the temperature of 100 $^\circ$C on the heating plate in the $N_2$ gas atomosphere (The first heating stage).

Next, the resist film 20 on the substrate 10 was exposed through a mask-pattern 5. (The exposing stage) The g line spectrum from a super-high pressure mercury (Hg) lamp (wavelength 436 nm) was used as the light source for the exposing stage and the numerical aperture (NA) of the objective lens was 0.45.

Next, just as the first heating stage, the substrate 10 was installed in the $N_2$ gas atomosphere, and then the resist film 20 on the substrate 10 was heated at approximately 110 $^\circ$C for approximately 1 minute (The second heating stage).

The resist film 20 on the substrate 10 was dipped into aqueous solution involved tetramethylammonium hydroxide 2.38 wt% (TMAH). Then, the resist film 20 was exposed for approximately 50 seconds for forming a resist pattern (The exposing stage).

Finally, the substrate 10 was heated for a postbaked treatment.

This completed the forming of the resist pattern.

The sectional shapes of the resist pattern formed by using the above descrived method and the conventional method were observed with a scanning electron micrograph (SEM). The magnification of x 20,000 in the SEM was used.

Fig. 1 A is a sectional view of the resist pattern formed by the resist pattern fabrication method of the invention.

Fig. 1 B is a sectional view of the resist pattern formed by the conventional resist pattern fabrication method.

Where the resist pattern formed by the method of this invention is compared with the resist pattern formed by the conventional method, the sectional shapes 20 of the resist pattern of the invention is rectangular and the edge 40 of the upper portion of the resist pattern 20 is in square shape as shown in Fig. 1A.

While, the edge 50 of the top portion of the resist pattern 30 of the conventional method is round in shape as shown in Fig. 1B.

Moreover, the sectional shape 20 of the resist pattern is exactly transferred on the substrate 10 (L = L1). The good resist pattern can be obtained by the resist pattern fabrication method of the invention.

On the other hand, in the Fig. 1B, the hem portion 60 of the resist pattern 30 is wider than that of the mask pattern 5 ( L < L2 ) and the spape of the resist pattern is poor. These images of the resist patterns 20 and 30 in Figs. 1A and 1B are in 0.50 $\mu$m/r.

In the conventional resist pattern fabrication method, the resist pattern 30 is formed in air at the first and second heating stages and other stages such as the coating stage, the exposing stage, and the development stage are all the same as in this invention.

Fig. 2 shows a relation between the mask pattern length (L) and the resist pattern lengths (L1 and L2).

In the drawing, a symbol '●' designates a length (L2) of the resist pattern formed by the conventional method, a symbol 'O' denotes a length of the resist pattern formed by the present invention.

When the resist pattern is exactly transferred through the mask pattern 5, a length of an obtained resist pattern is plotted on the diagonal line of 45° extended from the original point 0 as shown in Fig. 2.

When a shape of the mask pattern 5 is wide (for example, more than 0.6 $\mu$m in Fig. 2), the difference between the present invention and the prior art is little (see a1 and b1, a2 and b2, a3 and b3, and a4 and b4 in Fig. 2).

While, the shape of the mask pattern is narrow (for example, from 0.5 to 0.6 $\mu$m in Fig. 2), the resist pattern of the invention can be more exactly transferred than that of the prior art (see a5 and b6 in Fig. 2).

According to Fig. 2, the length up to 0.5 $\mu$m of the mask pattern can be transferred exactly by the present invention but the length up to 0.55$\mu$m of it can be transferred by the prior art.

Therefore the improvement of the resolution of 0.05 $\mu$m is achieved by the method of the invention.

In addition, the degree of the improvement equals to the improvement obtained when a lens having NA = 0.54 is used.

Where Resolution = R ( $\lambda$ / NA),
$\lambda$ is a wavelength of the exposing light,
R means process constant, and
NA denotes an numerical aperture.

As described in detail above, when the resist pattern fabrication method of this invention is used, the resist pattern is bonded strongly on the substrate for the exposing stage and the developing stage. Thereby, the resolution of the resist pattern can be increased and having a good shape is obtained.

The scope of this invention is not limited to the embodiment described above but includes many modifications and variations which will be obvious to one skilled in the art. For example, in the first heating stage, the rare gases (He, Ne, Ar, Kr, Xe and Rn gases) as inert gas or air instead of the $N_2$ gas can be used.

In addition, in the second heating stage, dry gas, for instance dry air, in place of the $N_2$ gas may also be applied to obtain the similar effect. In this case, the resist film becomes so hard and is bonded so strong to the substrate that the resist film becomes in more suitable state for the development.

Various modification will become possible for those skilled in the art after receiving the teachings of the present disclosure without departing from the scope thereof.

Reference signs in the claims are intended for better understanding and shall not limit the scope.

## Claims

1. A resist pattern fabrication method for forming the resist pattern (20) on a substrate, comprising:
a coating stage for forming a resist film (20) by coating a resist on the substrate (10);
a first heating stage for heating the resist film (20)- after installing the substrate (10) in a first gas atmosphere,
an exposing stage for exposing the resist film (20);
a second heating stage for heating the resist film (20) after installing the substrate (10) in a second gas atmosphere; and
a development stage for development of the resist film (20).

2. A resist pattern fabrication method according to claim 1, wherein the first gas and the second gas are Nitrogen gas ($N_2$ gas).

3. A resist pattern fabrication method according to claim 1, wherein the first gas and the second gas are inert gas (rare gases).

4. A resist pattern fabrication method according to claim 1, wherein the first gas is air and the second gas is dry gas.

5. A resist pattern fabrication method according to claim 1, wherein the first gas is air and the second gas is Nitrogen gas ($N_2$ gas).

6. A resist pattern fabrication method according to claim 1, wherein the first gas is air and the second gas is inert gas.

7. A resist pattern fabrication method according to claim 1, wherein the first gas is inert gas and the second gas is Nitrogen gas ($N_2$ gas).

8. A resist pattern fabrication method according to claim 1, wherein the first gas is inert gas and the second gas is dry gas.

9. A resist pattern fabrication method according to claim 1, wherein the first gas is Nitrogen gas ($N_2$ gas) and the second gas is dry gas.

10. A resist pattern fabrication method according to claim 1, wherein the first gas is Nitrogen gas ($N_2$ gas) and the second gas is inert gas.

# FIG.1A

EXPOSURE LIGHT

MASK PATTERN
LENGTH L

MASK
PATTERN 5

40    20

RESIST
PATTERN

10

RESIST PATTERN
LENGTH L1

# FIG.1B
## PRIOR ART

EXPOSURE LIGHT

MASK PATTERN
LENGTH L

MASK
PATTERN 5

50

30

60

10

RESIST PATTERN
LENGTH L2

EP 0 415 412 A2

# FIG.2